Europäisches Patentamt

European Patent Office

Office européen des brevets

(19)

(11) EP 0 680 614 B1

(12) **EUROPÄISCHE PATENTSCHRIFT**

(45) Veröffentlichungstag und Bekanntmachung des Hinweises auf die Patenterteilung:
**04.09.1996 Patentblatt 1996/36**

(21) Anmeldenummer: **94904131.3**

(22) Anmeldetag: **10.01.1994**

(51) Int Cl.⁶: $G01R\ 33/06$, $G01D\ 5/16$

(86) Internationale Anmeldenummer:
**PCT/DE94/00016**

(87) Internationale Veröffentlichungsnummer:
**WO 94/17426 (04.08.1994 Gazette 1994/18)**

(54) **VORRICHTUNG ZUM ERFASSEN EINER WINKELPOSITION EINES OBJEKTES**

DEVICE FOR DETECTING THE ANGULAR POSITION OF AN OBJECT

DISPOSITIF PERMETTANT DE DETECTER LA POSITION ANGULAIRE D'UN OBJET

(84) Benannte Vertragsstaaten:
**DE FR**

(30) Priorität: **22.01.1993 DE 4301704**

(43) Veröffentlichungstag der Anmeldung:
**08.11.1995 Patentblatt 1995/45**

(73) Patentinhaber: **SIEMENS AKTIENGESELLSCHAFT 80333 München (DE)**

(72) Erfinder:
- **VAN DEN BERG, Hugo D-91074 Herzogenaurach (DE)**
- **SCHELTER, Wolfgang D-91080 Uttenreuth (DE)**

(56) Entgegenhaltungen:
**EP-A- 0 406 060   EP-A- 0 485 129**
**EP-A- 0 498 668**

- **PATENT ABSTRACTS OF JAPAN vol. 6, no. 95 (E-110)3. Juni 1982 & JP,A,57 027 081 (COPAL CO LTD) 13. Februar 1982**
- **IEEE TRANSACTION ON MAGNETICS Bd. MAG-22, Nr. 5 , September 1986 , NEW YORK, USA Seiten 394 - 396 T.J. NELSON ET AL 'Shear-sensitive Magnetoresistive Robotic Tactile Sensor'**
- **IEEE TRANSACTION ON MAGNETICS Bd. MAG-22, Nr. 5 , September 1986 , NEW YORK,**
- **USA Seiten 394 - 396 T.J. NELSON ET AL 'Shear-sensitive Magnetoresistive Robotic Tactile Sensor'**

## Beschreibung

Die Erfindung betrifft eine Vorrichtung zum Erfassen einer Winkelposition eines Objektes gemäß dem Oberbegriff des Anspruchs 1, die beispielsweise aus den "Technischen Informationen TI 901228 der Fa. Philips, Eigenschaften und Anwendungen der Magnetfeldsensoren KMZ 10" bekannt ist.

In einer Ausführungsform dieser bekannten Vorrichtung zum Messen einer Winkelposition ist ein magnetoresistiver Barberpole-Sensor im Feld eines drehbar gelagerten Magneten angeordnet.

Magnetoresistive Sensoren sind im allgemeinen aus einer dünnen Schicht aus einem magnetoresistiven Material aufgebaut, das in der Schichtebene magnetisiert ist. Bei Drehung der Magnetisierung der Schicht bezüglich der Stromrichtung eines in der Schicht fließenden Meßstromes durch ein zu messendes Magnetfeld tritt eine Widerstandsänderung auf, die einige Prozent des normalen isotropen Widerstandes betragen kann und als Meßsignal erfaßt wird. Diesen Effekt nennt man anisotropen Magnetowiderstand (AMR) oder anisotropen magnetoresistiven Effekt. Übliche magnetoresistive Materialien sind ferromagnetische Übergangsmetalle wie Nickel (Ni), Eisen (Fe) oder Kobalt (Co) und Legierungen mit diesen Metallen. Bei dem in der bekannten Winkelmeßvorrichtung eingesetzten magnetoresistiven Barberpole-Sensor ist wenigstens ein rechteckiger Streifen aus der ferromagnetischen NiFe-Legierung mit dem Handelsnamen "Permalloy" vorgesehen, der in seiner Längsrichtung magnetisiert ist. Auf dem Permalloy-Streifen sind mehrere dünne Metallstreifen unter einem Winkel von 45° gegen die Längsrichtung des Permalloy-Streifens nebeneinander angeordnet. Wird nun an den Permalloy-Streifen in seiner Längsrichtung eine Spannung angelegt, so bildet sich zwischen den Metallstreifen ein elektrischer Strom aus, der im wesentlichen unter einem Winkel von ±45° oder ±135° entsprechend der Polung der Spannung zur Magnetisierung des Permalloy-Streifens gerichtet ist. Ein äußeres, zu messendes Magnetfeld mit einer Komponente senkrecht zur Magnetisierung dreht nun die Magnetisierung des Permalloystreifens relativ zur gleichbleibenden Stromrichtung. Diese Drehung führt zu einer Widerstandsänderung, die annähernd linear vom Magnetfeld abhängt. Die Widerstandskennlinie eines solchen Barberpole-Sensors ist eindeutig und wenigstens annähernd linear für einen Winkelbereich von annähernd 90°, der beispielsweise zwischen einem Winkel zwischen der Magnetisierung und dem Meßstrom von etwa +45° und etwa -45° oder auch einem Winkel von etwa -45° bis etwa +45° gewählt werden kann.

Das Magnetfeld des drehbaren Magneten ist dabei sowohl als Meßfeld als auch als Stützfeld zur Stabilisierung der Sensorkennlinie vorgesehen. Eine Drehung des Magneten um einen zu messenden Winkel bewirkt nun eine Änderung des Widerstandssignals des Barberpole-Sensors. Der Meßbereich dieser Winkelmeßvorrichtung ist auf maximal etwa ±90° beschränkt, weil der Sensor nur in diesem Winkelbereich eine eindeutige Kennlinie aufweist. Größere Winkel bis zu ±13,5° können durch ein Stützfeld eines weiteren Magneten erreicht werden. Winkel bis fast ±180° sind durch die Verwendung von zwei rechtwinklig zueinander angeordneten Sensoren und eine Auswertung ihrer Meßsignale in den einzelnen Winkelquadranten erreichbar. Mögliche Anwendungen dieser bekannten Vorrichtung sind Gaspedal- und Drosselklappengeber im Kraftfahrzeug, Neigungssensoren sowie Windrichtungsanzeiger.

In einer anderen, als Kompaß vorgesehenen Ausführungsform sind zwei senkrecht gekreuzte Barberpole-Sensoren drehbar in dem Magnetfeld einer Spule angeordnet, die zum Ummagnetisieren der Sensoren vorgesehen ist ("Technische Informationen TI 901228" der Firma Philips Components).

Es sind Mehrschichtsysteme bekannt mit mehreren, zu einem Stapel angeordneten ferromagnetischen Schichten, die durch nichtmagnetische metallische Zwischenschichten voneinander getrennt sind, und deren Magnetisierungen jeweils in der Schichtebene liegen. Die jeweiligen Schichtdicken sind dabei wesentlich kleiner als die mittlere freie Weglänge der Leitungselektronen gewählt. In solchen Schichtsystemen tritt nun bei Anlegen eines elektrischen Stromes zusätzlich zu dem anisotropen magnetoresistiven Effekt in den einzelnen Schichten der sogenannte Giant-magnetoresistive Effekt oder Giant-Magnetowiderstand (Giant-MR) auf, der auf der unterschiedlich starken, von der jeweiligen Magnetisierung abhängigen Streuung von Majoritäts- und Minoritäts-Leitungselektronen im Volumen der Schichten, insbesondere in Legierungen, sowie an den Grenzflächen zwischen den ferromagnetischen Schichten und den Zwischenschichten beruht. Dieser Giant-MR ist ein isotroper Effekt, d.h. er ist insbesondere unabhängig von der Stromrichtung, und , kann erheblich größer sein als der anisotrope MR mit Werten von bis zu 70 % des normalen isotropen Widerstandes.

Es sind zwei Grundtypen von solchen Giant-MR-Mehrschichtsystemen bekannt. Bei dem ersten Typ sind die ferromagnetischen Schichten über die Zwischenschichten antiferromagnetisch aneinander gekoppelt, so daß sich die in den Schichtebenen liegenden Magnetisierungen von zwei benachbarten ferromagnetischen Schichten ohne äußeres Magnetfeld antiparallel zueinander ausrichten. Ein Beispiel für diesen Typ sind Eisen-Chrom-Übergitter (Fe-Cr-Superlattices) mit ferromagnetischen Schichten aus Fe und antiferromagnetischen Zwischenschichten aus Cr. Durch ein entsprechend gerichtetes äußeres Magnetfeld werden nun die Magnetisierungen von benachbarten ferromagnetischen Schichten gegen die antiferromagnetischen Kopplungskräfte gedreht und parallel ausgerichtet. Diese Umorientierung der Magnetisierungen durch das Magnetfeld hat eine stetige Abnahme des Giant-MR zur Folge, die ein Maß für die Größe des Magnetfeldes ist. Bei einer Sättigungsfeldstärke $H_S$ tritt keine Änderung des Giant-MR mehr auf, weil sämtliche Magnetisierungen dann parallel zueinander ausgerichtet sind ("Physical Review Letters", Vol. 61, No. 21, 21. Nov. 1988, Seiten 2472 - 2475).

Bei dem zweiten Typ eines Giant-MR-Mehrschichtsystems sind die ferromagnetischen Schichten durch dia- oder paramagnetische Zwischenschichten aus Metall voneinander getrennt. Die Zwischenschichten sind so dick gewählt, daß die magnetische Austauschkopplung zwischen den Magnetisierungen der ferromagnetischen Schichten möglichst gering ist. Jeweils benachbarte ferromagnetische Schichten weisen unterschiedliche Koerzitivfeldstärken auf.

An einem derartigen austauschentkoppelten Giant-MR-Schichtsystem mit magnetisch weicheren Meßschichten aus $Ni_{80}Fe_{20}$ und durch Zwischenschichten aus Cu von den Meßschichten getrennten, magnetisch härteren Biasschichten aus Co wurden bereits Messungen des Widerstands in Abhängigkeit von dem Winkel THETA zwischen einem Sättigungsmagnetfeld $H_o$ und einem sich parallel zu den Schichtebenen drehenden Magnetfeld $H_r$ durchgeführt. Das Drehfeld $H_r$ wurde dabei so groß gewählt, daß nur die Magnetisierungen $M_1$ der Meßschichten der Drehung des Magnetfeldes $H_r$ folgen und die Magnetisierungen $M_2$ der Biasschichten in ihrer durch das Sättigungsfeld $H_o$ vorgegebenen, ursprünglichen Richtung verharren. Es ergab sich, daß sich der gesamte elektrische Widerstand R des Schichtsystems in Abhängigkeit vom Winkel THETA in guter Näherung als Summe aus einem Anteil $A_1$ * cos (THETA) für den Giant-MR, einem Anteil $A_2$ * cos (2* THETA) für den AMR und einem konstanten Ohmschen Anteil $R_o$ darstellen läßt, wobei der Koeffizient $A_2$ des AMR-Anteils positiv und der Koeffizient $A_1$ des Giant-MR-Anteils negativ und betragsmäßig etwa 60 mal größer als $A_2$ sind. ("Journal of Magnetism and Magnetic Materials" (North-Holland), Vol. 113, 1992, Seiten 79 - 82).

Der Erfindung liegt nun die Aufgabe zugrunde, eine Vorrichtung zum Messen einer Winkelposition eines Objektes der eingangs genannten Art derart zu verbessern, daß ein Winkelmeßbereich von wenigstens 180°, eine höhere Empfindlichkeit und ein größerer Feldbereich erreicht werden.

Diese Aufgabe wird gemäß der Erfindung gelöst mit den Merkmalen des Anspruchs 1.

Mit der Verwendung eines Giant-MR-Sensors erreicht man wegen der cos(THETA)-Abhängigkeit des Giant-MR vom Drehwinkel THETA zwischen einem sich in der Schichtebene drehenden Magnetfeld $\bar{H}$ und einem Ausgangsmagnetfeld $\bar{H}_o$ im Gegensatz zur cos(2* THETA)-Abhängigkeit des AMR wenigstens eine Verdoppelung des Meßbereichs. Außerdem kann die Empfindlichkeit auf bis etwa das Zehnfache gesteigert werden, und es können größere Magnetfelder eingesetzt werden.

In einer Ausführungsform wird eine Änderung der Winkelposition in eine Drehung eines Magnetfeldes $\bar{H}$

umgesetzt, während in einer Ausführungsform die Änderung der Winkelposition in eine entsprechende Drehung des Magnetowiderstands-Sensors gegenüber einem wenigstens annähernd konstanten, äußeren Magnetfeld $\bar{H}_g$ übergeführt wird. Die erste Ausführungsform ist beispielsweise für Gaspedal- oder Drosselklappengeber im Kraftfahrzeug geeignet, wo Winkel von etwa 140° auftreten, und vorzugsweise für ein kontaktloses Potentiometer zu verwenden und letztere Ausführungsform ist vorzugsweise als Kompaß einzusetzen.

Vorteilhafte weitere Ausgestaltungen gemäß der Erfindung ergeben sich aus den weiteren Unteransprüchen.

Zur weiteren Erläuterung der Erfindung wird auf die Zeichnung Bezug genommen, in deren

FIG. 1      eine Vorrichtung zum Messen einer Winkelposition mit drehbarem Magneten,

FIG. 2      eine Vorrichtung zum Messen einer Winkelposition mit drehbarem Giant-MR-Sensor und

FIG. 3 und 4      jeweils ein Giant-MR-Schichtsystem für eine Vorrichtung gemäß der Erfindung

schematisch dargestellt sind. Einander entsprechende Teile sind mit denselben Bezugszeichen versehen.

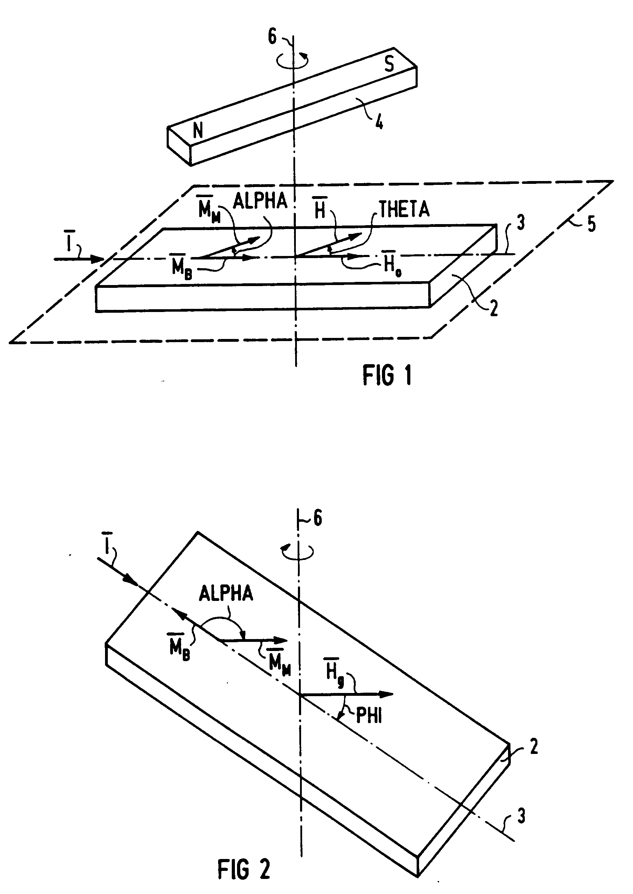

In der Ausführungsform gemäß FIG. 1 ist ein MR-Sensor 2 mit einem nicht näher dargestellten Giant-MR-Schichtsystem vorgesehen, der in dem Magnetfeld eines um eine Drehachse 6 drehbaren Magneten 4 angeordnet ist. Der Magnet 4 erzeugt dabei ein Magnetfeld mit einer Komponente $\bar{H}$ in einer senkrecht zur Drehachse 6 gerichteten Drehebene 5, die parallel zu den Schichtebenen der einzelnen Schichten des Giant-MR-Schichtsystems gerichtet ist. Der MR-Sensor 2 weist eine Bezugsachse 3 in der Drehebene 5 auf und wird während der Messung von einem elektrischen Strom $\bar{I}$ durchflossen, der vorzugsweise parallel zur Bezugsachse 3 und zu den Schichtebenen gerichtet ist, jedoch auch senkrecht zu den Schichtebenen und zur Bezugsachse 3 verlaufen kann. Das Schichtsystem enthält wenigstens eine Meßschicht mit einer durch das Magnetfeld $\bar{H}$ drehbaren Magnetisierung $\bar{M}_M$ und wenigstens eine Biasschicht mit einer bezogen auf die Bezugsachse 3 zumindest annähernd festen (drehinvarianten) Magnetisierung $\bar{M}_B$. Der MR-Sensor 2 mit dem Schichtsystem ist als länglicher Streifen ausgebildet, dessen Längsrichtung der Bezugsachse 3 entspricht. Vorzugsweise ist auch die Magnetisierung $\bar{M}_B$ der Biasschicht parallel zur Längsrichtung des MR-Sensors 2 gerichtet. Dadurch können die entmagnetisierenden Felder abgeschwächt werden.

In einer besonders vorteilhaften, nicht dargestellten Ausführungsform sind der MR-Sensor 2 und die Schichten seines Giant-MR-Schichtsystems wenigstens annähernd kreisrund ausgebildet, um störende Randeffekte durch entmagnetisierende Felder zu reduzieren.

Ist nun das Magnetfeld $\bar{H}$ des Magneten 4 in seiner Ausgangslage parallel zur Bezugsachse 3 des MR-Sensors 2, die als Ausgangsmagnetfeld $\bar{H}_o$ bezeichnet ist, so sind die Magnetisierungen $\bar{M}_M$ der Meßschicht und $\bar{M}_B$ der Biasschicht parallel zueinander gerichtet und der Winkel ALPHA zwischen ihnen ist 0°. Der Winkel ALPHA kann allerdings auch 180° betragen, wenn die Magnetisierung $\bar{M}_B$ antiparallel zum Ausgangsmagnetfeld $\bar{H}_o$ gewählt wird. Wird der Magnet 4 um die Drehachse 6 gedreht, so dreht sich das Magnetfeld $\bar{H}$ in der Drehebene 5 um einen entsprechenden Drehwinkel THETA gegenüber dem Ausgangsmagnetfeld $\bar{H}_o$.

Gleichzeitig wird auch die Magnetisierung $\bar{M}_M$ der Meßschicht mitgedreht, so daß sich ein neuer Winkel ALPHA zwischen der gedrehten Magnetisierung $\bar{M}_M$ der Meßschicht und der festen Magnetisierung $\bar{M}_B$ der Biasschicht einstellt. Dieser Winkel ALPHA ist im allgemeinen etwa gleich dem Drehwinkel THETA bzw. gleich 180°+THETA. Der elektrische Widerstand R des von dem Strom $\bar{I}$ durchflossenen Giant-MR-Schichtsystems ist nun in einem Winkelbereich von 180° eindeutig abhängig von dem Winkel ALPHA zwischen den beiden Magnetisierungen $\bar{M}_M$ und $\bar{M}_B$, und zwar ist der Widerstand R maximal für ALPHA = 180° und minimal für ALPHA = 0°.

Mit dieser Vorrichtung kann nun eine Winkelposition eines in einer zur Drehebene 5 parallelen Ebene liegenden Körpers gemessen werden, indem man beispielsweise über eine Welle dessen Winkelpositionsänderung in eine Drehung des Magneten 4 um die Drehachse 6 umsetzt und den Widerstand R des MR-Sensors 2 mißt.

In einer besonders vorteilhaften Ausführungsform ist die Vorrichtung als kontaktloses Potentiometer vorgesehen.

Durch eine Dreheinrichtung, beispielsweise einen Stellknopf, werden über eine Welle der Magnet 4 und sein Magnetfeld H gedreht, und der Widerstand R des Schichtsystems wird entsprechend verändert. Ein solches Potentiometer hat den Vorteil, daß sein elektrisch kontaktierter Teil nicht mechanisch mit dem drehenden Teil gekoppelt ist. Man kann daher zusätzliche Trennwände zwischen diesen beiden Teilen, nämlich dem Magneten 4 mit der Welle und der Dreheinrichtung einerseits und dem Schichtsystem mit entsprechend elektrischen Kontakten andererseits, anordnen, solange diese Trennwände das Streufeld des Magneten 4 nicht zu sehr abschwächen. Außerdem ist bei diesem Potentiometer ein gegen Verschleiß und Korrosion anfälliger Schleifkontakt nicht mehr notwendig.

Eine weitere vorteilhafte Anwendung der Vorrichtung gemäß der Erfindung ist die Drehzahlmessung und -regelung von Elektromotoren. Die Drehachse 6 wird dabei vorzugsweise parallel zur Laufachse des Elektromotors angeordnet. Es sind nun Mittel zum Messen der Drehzahl vorgesehen durch Messen der Winkelposition der Motorachse in regelmäßigen Zeitintervallen. Gegenüber bekannten induktiven Aufnehmern hat dieser Drehzahlmesser den Vorteil, daß auch niedrige Drehzahlen erfaßt werden können und daß das Signal drehzahlunabhängig ist.

Mit einer Anordnung von zwei MR-Sensoren mit senkrecht zueinander gerichteten Bezugsachsen kann überdies sowohl die ruhende als auch die bewegte absolute Winkelposition der Motorachse durch eine Quadratur der Meßsignale der beiden MR-Sensoren bestimmt werden.

FIG. 2 zeigt eine Ausführungsform mit einem um die Drehachse 6 drehbaren MR-Sensor, der in einem räumlich festen Magnetfeld $\bar{H}_g$ angeordnet ist. Diese Vorrichtung eignet sich vor allem als Kompaß, wobei das Magnetfeld $\bar{H}_g$ dann das Erdmagnetfeld ist. Eine Drehung der Bezugsachse 3 des MR-Sensors 2 um einen Drehwinkel PHI aus einer Ausgangslage parallel zum Magnetfeld $\bar{H}_g$ führt wieder zu einer entsprechenden Drehung der Magnetisierung $\bar{M}_M$ der Meßschicht. Es stellt sich ein Winkel ALPHA zwischen den Magnetisierungen $\bar{M}_M$ und $\bar{M}_B$ der Meßschicht bzw. der Biasschicht ein und in Abhängigkeit von diesem Winkel ALPHA ändert sich das Widerstandssignal des MR-Sensors 2.

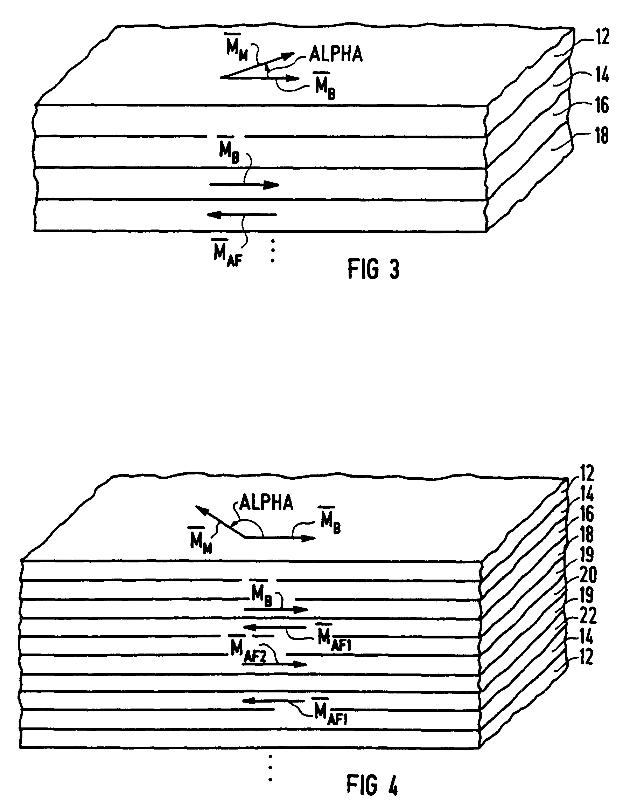

In den FIG. 3 und 4 sind Ausführungsformen von Giant-MR-Schichtsystemen gemäß der Erfindung veranschaulicht.

FIG. 3 zeigt eine Ausführungsform mit einer Meßschicht 12 mit einer Magnetisierung $\bar{M}_M$ in ihrer Schichtebene und einer Biasschicht 16 mit einer festen Magnetisierung $\bar{M}_B$ in ihrer Schichtebene. Die Meßschicht 12 und die Biasschicht 16 sind über eine elektrisch leitende, nicht magnetische Zwischenschicht 14 magnetisch weitgehend austauschentkoppelt. Zwischen den beiden Magnetisierungen $\bar{M}_M$ und $\bar{M}_B$ stellt sich entsprechend der Lage des nicht dargestellten Magnetfeldes $\bar{H}$ ein Winkel ALPHA ein. Die Magnetisierung $\bar{M}_B$ der Biasschicht 16 ist durch eine auf der von der Meßschicht 12 abgewandten Seite antiferromagnetisch an die Biasschicht 16 angekoppelte zusätzliche Magnetschicht 18 mit einer zu $\bar{M}_B$ antiparallelen Magnetisierung $\bar{M}_{AF}$ stabilisiert.

In einer anderen, nicht dargestellten Ausführungsform ist die Biasschicht 16 mit einer Vorzugsachse versehen und parallel zu dieser Vorzugsachse magnetisiert.

In einer weiteren Ausführungsform gemäß FIG. 4 ist an die Biasschicht 16 ein antiferromagnetisches Schichtsystem antiferromagnetisch angekoppelt, das aus zwei Magnetschichten 18 und 22 mit gleichgerichteten Magnetisierungen $\bar{M}_{AF1}$ in den Schichtebenen und einer dazwischen angeordneten dritten Magnetschicht 20 mit einer zu $\bar{M}_{AF1}$ antiparallelen Magnetisierung $\bar{M}_{AF2}$, die jeweils über eine Zwischenschicht 19 an die Magnetschichten 18 bzw. 22 antiferromagnetisch angekoppelt ist, besteht. Auch mit dieser Anordnung der Schichten kann die Magnetisierung $\bar{M}_B$ der Biasschicht 16 in ihrer Richtung fixiert werden.

Das antiferromagnetische Schichtsystem kann auch aus nur zwei antiferromagnetisch gekoppelten Magnetschichten aufgebaut sein.

Zwischen den Magnetschichten des antiferromagnetischen Schichtsystems sind vorzugsweise Zwischenschichten angeordnet. Zwischen der Biasschicht 16 und dem antiferromagnetisch angekoppelten antiferromagnetischen Schichtsystem oder der einzelnen Schicht in der Ausführungsform gemäß FIG. 3 kann ebenfalls eine Zwischenschicht angeordnet sein.

In einer besonderen Ausführungsform sind die Meßschicht 14 und die Biasschicht 16, vorzugsweise über eine Zwischenschicht, antiferromagnetisch oder ferromagnetisch aneinander austauschgekoppelt, so daß ihre Magnetisierungen $\overline{M}_M$ und $\overline{M}_B$ ohne Magnetfeld H antiparallel bzw. parallel zueinander gerichtet sind.

Vorzugsweise ist eine Vielzahl von den bisher beschriebenen Schichtsystemen mit einer Meßschicht 12 und einer Biasschicht 16 zu einem vorzugsweise periodischen Stapel angeordnet. Typischerweise werden bis etwa 100 solcher Schichtsysteme aufeinandergestapelt.

Zur Messung wird das gesamte Giant-MR-Schichtsystem mit wenigstens zwei Kontakten versehen. Diese Kontakte werden entweder beide auf der obersten Schicht angeordnet, so daß der Strom $\overline{I}$ im Mittel parallel zu den Schichtebenen fließt (current-in-plane = cip), oder es wird jeweils ein Kontakt auf der obersten und auf der untersten Schicht angeordnet, so daß der Strom $\overline{I}$ im Mittel senkrecht zu den Schichtebenen fließt (current-perpendicular-to-planes = cpp).

**Patentansprüche**

1. Vorrichtung zum Erfassen einer Winkelposition eines Objekts bezüglich einer vorgegebenen Nullage mit einem Magnetowiderstands(MR)-Sensor (2), der eine feste Bezugsachse (3) und Kontakte zum Einspeisen eines elektrischen Stromes ($\overline{I}$) aufweist sowie in einem Magnetfeld angeordnet ist, wobei eine Magnetfeldkomponente ($\overline{H}$ oder $\overline{H}_g$) des Magnetfeldes und die Bezugsachse (3) des MR-Sensors (2) in einer Drehebene (5) gegeneinander um einen Drehwinkel (THETA bzw. PHI) drehbar sind, der mit der zu erfassenden Winkelposition eindeutig korreliert ist und der elektrische Widerstand des MR-Sensors (2) eindeutig von diesem Drehwinkel (THETA bzw. PHI) abhängt, **dadurch gekennzeichnet**, daß der MR-Sensor (2) mit einem Schichtsystem aus mehreren aufeinander angeordneten Schichten mit wenigstens annähernd parallel zur Drehebene (5) gerichteten Schichtebenen gebildet ist, welches Schichtsystem

    (i) wenigstens eine Meßschicht (12) mit einer durch das Magnetfeld ($\overline{H}$ bzw. $\overline{H}_g$) in ihrer Schichtebene drehbaren Magnetisierung ($\overline{M}_M$),

    (ii) wenigstens eine Biasschicht (16) mit einer von dem Magnetfeld ($\overline{H}$ bzw. $\overline{H}_g$) im wesentlichen unabhängigen Magnetisierung ($\overline{M}_B$) in ihrer Schichtebene und

    (iii) wenigstens eine auf der von der Meßschicht (12) abgewandten Seite wenigstens einer Biasschicht (16) angeordnete und antiferromagnetisch mit der Biasschicht (16) gekoppelte Magnetschicht (18) enthält,

    wobei der elektrische Widerstand des Schichtsystems von dem Winkel (ALPHA) zwischen der Magnetisierung ($\overline{M}_M$) der Meßschicht (12) und der Magnetisierung ($\overline{M}_B$) der Biasschicht (16) abhängt.

2. Vorrichtung nach Anspruch 1, bei der die Biasschicht (16) mit der Magnetschicht (18) direkt verbunden ist.

3. Vorrichtung nach Anspruch 1, bei der die Biasschicht (16) über eine Zwischenschicht (17) mit der Magnetschicht (18) verbunden ist.

4. Vorrichtung nach einem der Ansprüche 1 bis 3, bei der auf der von der Biasschicht (16) abgewandten Seite der an die Biasschicht (16) antiferromagnetisch angekoppelten Magnetschicht (18) eine weitere Magnetschicht (20) angeordnet ist und die beiden Magnetschichten (18 und 20) antiferromagnetisch aneinander gekoppelt sind.

5. Vorrichtung nach Anspruch 4, bei der zwischen den Magnetschichten (18, 20 bzw. 22) eine Zwischenschicht (19) angeordnet ist.

6. Vorrichtung nach einem der Ansprüche 1 bis 5, bei der

    a) der MR-Sensor (2) räumlich fest angeordnet ist und
    b) Mittel (4) vorgesehen sind zum Erzeugen eines gegenüber der Bezugsachse (3) des MR-Sensors (2) in der Drehebene (5) drehbaren Magnetfeldes ($\overline{H}$).

7. Vorrichtung nach Anspruch 6 zur Verwendung als kontaktloses Potentiometer.

8. Vorrichtung nach einem der Ansprüche 1 bis 5, bei der

    a) das Magnetfeld ($\overline{H}_g$) räumlich fest ist und
    b) die Bezugsachse (3) des MR-Sensors (2) in der Drehebene (5) drehbar ist.

9. Vorrichtung nach einem der vorhergehenden Ansprüche, bei der die Meßschicht (12) von der Biasschicht (16) durch eine Zwischenschicht (14) wenigstens annähernd magnetisch austauschentkoppelt ist.

10. Vorrichtung nach einem der vorhergehenden Ansprüche, bei der die Biasschicht (16) eine Koerzitivfeldstärke aufweist, die betragsmäßig größer ist als das Magnetfeld ($\overline{H}$ bzw. $\overline{H}_g$), und die Meßschicht (12) eine Koerzitivfeldstärke aufweist, die betragsmäßig kleiner ist als das Magnetfeld ($\overline{H}$ bzw. $\overline{H}_g$).

11. Vorrichtung nach einem der Ansprüche 1 bis 8, bei der die Meßschicht (12) und die Biasschicht (16) durch eine Zwischenschicht (14) austauschgekoppelt sind.

12. Vorrichtung nach einem der vorhergehenden Ansprüche, bei der die Biasschicht (16) mit einer magnetischen Vorzugsachse versehen ist und entlang dieser Vorzugsachse magnetisiert ist.

13. Vorrichtung nach einem der vorhergehenden Ansprüche, bei der die Schichten zu einem Stapel mit periodischer Schichtfolge angeordnet sind.

14. Vorrichtung nach einem der vorhergehenden Ansprüche, bei der das Schichtsystem wenigstens annähernd kreisförmig ausgebildet ist.

15. Vorrichtung nach einem der vorhergehenden Ansprüche, bei der Mittel zum Erfassen einer Drehbewegung durch Erfassen der Winkelposition in regelmäßigen zeitlichen Abständen vorgesehen sind.

16. Vorrichtung nach einem der vorhergehenden Ansprüche, bei der zwei MR-Sensoren vorgesehen sind mit senkrecht zueinander gerichteten Bezugsachsen.

## Claims

1. Arrangement for detecting an angular position of an object in relation to a given zero position with a magnetoresistive (MR)-sensor (2) which has a fixed reference axis (3) and contacts for the supply of an electric current ($\overline{I}$) and is also arranged in a magnetic field, wherein one magnetic field component ($\overline{H}$ or $\overline{H}_g$) of the magnetic field and the reference axis (3) of the MR-sensor (2) can be rotated relative to each other in a plane of rotation (5) about an angle of rotation (THETA or PHI respectively) which is clearly correlated with the angular position which is to be detected, and the electrical resistance of the MR-sensor (2) is clearly a function of this angle of rotation (THETA or PHI respectively), characterised in that the MR-sensor (2) is formed with a layer system consisting of several layers which are arranged one on top of the other with the planes of the layers being aligned so as to be at least substantially parallel to the plane of rotation (5), which layer system contains

(i) at least one measurement layer (12) with a magnetization ($\overline{M}_M$) which can be rotated in the plane of the layer through the magnetic field ($\overline{H}$ or $\overline{H}_g$),
(ii) at least one biasing layer (16) with a magnetization ($\overline{M}_B$) in the plane of the layer that is substantially independent of the magnetic field ($\overline{H}$ or $\overline{H}_g$), and
(iii) at least one magnetic layer (18) which is arranged on that side of at least one biasing layer (16) that is remote from the measurement layer (12) and which magnetic layer (18) is antiferromagnetically coupled with the biasing layer (16),

wherein the electrical resistance of the layer system is a function of the angle (ALPHA) between the magnetization ($\overline{M}_M$) of the measurement layer (12) and the magnetization ($\overline{M}_B$) of the biasing layer (16).

2. Arrangement according to claim 1, wherein the biasing layer (16) is directly connected with the magnetic layer (18).

3. Arrangement according to claim 1, wherein the biasing layer (16) is connected with the magnetic layer (18) by way of an intermediate layer (17).

4. Arrangement according to one of the claims 1 to 3, wherein a further magnetic layer (20) is arranged on that side of the magnetic layer (18) that is remote from the biasing layer (16), the magnetic layer (18) being antiferromagnetically coupled to the biasing layer (16), and the two magnetic layers (18 and 20) are antiferromagnetically coupled to each other.

5. Arrangement according to claim 4, wherein an intermediate layer (19) is arranged between the magnetic layers (18, 20 and 22 respectively).

6. Arrangement according to one of the claims 1 to 5, wherein

a) the MR-sensor (2) is fixedly arranged in space; and
b) means (4) are provided in order to generate a magnetic field ($\overline{H}$) which can be rotated relative to the reference axis (3) of the MR-sensor (2) in the plane of rotation (5).

**7.** Arrangement according to claim 6 for use as a non-contacting potentiometer.

**8.** Arrangement according to one of the claims 1 to 5, wherein

a) the magnetic field ($\overline{H}_g$) is fixed with regard to space; and
b) the reference axis (3) of the MR-sensor (2) can be rotated in the plane of rotation (5).

**9.** Arrangement according to one of the preceding claims, wherein the measurement layer (12) is at least substantially magnetically exchange-decoupled from the biasing layer (16) by means of an intermediate layer (14).

**10.** Arrangement according to one of the preceding claims, wherein the biasing layer (16) has a coercive field strength which is quantitatively greater than the magnetic field ($\overline{H}$ or $\overline{H}_g$), and the measurement layer (12) has a coercive field strength which is quantitatively smaller than the magnetic field ($\overline{H}$ or $\overline{H}_g$).

**11.** Arrangement according to one of the claims 1 to 8, wherein the measurement layer (12) and the biasing layer (16) are exchange-coupled by means of an intermediate layer (14).

**12.** Arrangement according to one of the preceding claims, wherein the biasing layer (16) is provided with a preferred magnetic axis and is magnetized along this preferred axis.

**13.** Arrangement according to one of the preceding claims, wherein the layers are arranged to form a stack with a periodic sequence of layers.

**14.** Arrangement according to one of the preceding claims, wherein the layer system is formed so as to be at least substantially circular.

**15.** Arrangement according to one of the preceding claims, wherein means are provided to detect rotational movement by detecting the angular position at regular intervals with respect to time.

**16.** Arrangement according to one of the preceding claims, wherein two MR-sensors are provided that have reference axes which are aligned so as to be perpendicular to each other.

**Revendications**

**1.** Dispositif de détection d'une position angulaire d'un objet par rapport à une position prescrite de zéro, comportant un capteur (2) à magnétorésistance (MR), qui comporte un axe fixe (3) de référence et des contacts pour amener un courant électrique ($\overline{I}$) et qui est disposé dans un champ magnétique, une composante ($\overline{H}$ ou $\overline{H}_g$) du champ magnétique et l'axe (3) de référence du capteur (2) à magnétorésistance pouvant tourner dans un plan (5) de rotation l'un par rapport à l'autre d'un angle (THETA ou PHI) de rotation, qui est corrélé de manière univoque avec la position angulaire à détecter, la résistance électrique du capteur (2) à magnétorésistance dépendant de manière univoque de cet angle (THETA ou PHI) de rotation, caractérisé en ce que le capteur (2) à magnétorésistance est formé d'un stratifié constitué de plusieurs couches disposées l'une sur l'autre et ayant des plans de couches dirigés au moins approximativement parallèlement au plan (5) de rotation, lequel stratifié

(i) comprend au moins une couche (12) de mesure ayant une magnétisation ($\overline{M}_M$) pouvant tourner dans son plan de couche du fait du champ magnétique ($\overline{H}$ ou $\overline{H}_g$),
(ii) au moins une couche (16) de polarisation ayant une magnétisation ($\overline{M}_B$) dirigée dans son plan de couche et sensiblement indépendante du champ magnétique ($\overline{H}$ ou $\overline{H}_g$) et
(iii) au moins une couche magnétique (18) disposée du côté d'au moins une couche (16) de polarisation, qui est éloigné de la couche (12) de mesure, et couplée de manière anti-ferromagnétique à la couche (16) de polarisation,

la résistance électrique du stratifié de couche dépendant de l'angle (ALPHA) entre la magnétisation ($\overline{M}_M$) de la couche (12) de mesure et la magnétisation ($\overline{M}_B$) de la couche (16) de polarisation.

**2.** Dispositif suivant la revendication 1, dans lequel la couche (16) de polarisation est reliée directement à la couche magnétique (18).

**3.** Dispositif suivant la revendication 1, dans lequel la couche (16) de polarisation est reliée à la couche magnétique (18) par l'intermédiaire d'une couche intermédiaire (17).

**4.** Dispositif suivant l'une des revendications 1 à 3, dans lequel il est disposé du côté de la couche magnétique (18) couplée de manière anti-ferromagnétique à la couche (16) de polarisation, qui est éloigné de la couche (16) de polarisation une autre couche magnétique (20) et les deux couches magnétiques (18, 20) sont couplées l'une à l'autre de manière antiferromagnétique.

**5.** Dispositif suivant la revendication 4, dans lequel il est disposé entre les couches magnétiques (18, 20 ou 22) une couche intermédiaire (19).

**6.** Dispositif suivant l'une des revendications 1 à 5, dans lequel

     a) le capteur (2) à magnétorésistance est disposé de manière fixe dans l'espace et
     b) il est prévu des moyens (4) pour produire un champ magnétique ($\overline{H}$) pouvant tourner par rapport à l'axe (3) de référence du capteur (2) à magnétorésistance dans le plan (5) de rotation.

**7.** Dispositif suivant la revendication 6 destiné à être utilisé comme potentiomètre sans contact.

**8.** Dispositif suivant l'une des revendications 1 à 5, dans lequel

     a) le champ magnétique ($\overline{H}_g$) est fixe dans l'espace et
     b) l'axe (3) de référence du capteur (2) à magnétorésistance est tournant dans le plan (5) de rotation.

**9.** Dispositif suivant l'une des revendications précédentes, dans lequel la couche (12) de mesure est découplée par échange au moins approximativement magnétiquement de la couche (16) de polarisation par une couche intermédiaire (14).

**10.** Dispositif suivant l'une des revendications précédentes, dans lequel la couche (16) de polarisation a un champ coercitif, dont le module est plus grand que le champ magnétique ($\overline{H}$ ou $\overline{H}_g$) et la couche (12) de mesure a un champ coercitif, dont le module est plus petit que le champ magnétique ($\overline{H}$ ou $\overline{H}_g$).

**11.** Dispositif suivant l'une des revendications 1 à 8, dans lequel la couche (12) de mesure et la couche (16) de polarisation sont couplées par échange par une couche intermédiaire (14).

**12.** Dispositif suivant l'une des revendications précédentes, dans lequel la couche (16) de polarisation a un axe magnétique préféré et est magnétisée le long de cet axe préféré.

**13.** Dispositif suivant l'une des revendications précédentes, dans lequel les couches sont disposées en une pile dont les couches se suivent périodiquement.

**14.** Dispositif suivant l'une des revendications précédentes, dans lequel le stratifié a une forme au moins approximativement circulaire.

**15.** Dispositif suivant l'une des revendications précédentes, dans lequel il est prévu des moyens de détection d'un mouvement de rotation par détection de la position angulaire à intervalles de temps régulier.

**16.** Dispositif suivant l'une des revendications précédentes, dans lequel il est prévu deux capteurs à magnétorésistance d'axes de référence perpendiculaires l'un à l'autre.

FIG 1

FIG 2

$\overline{M}_M$ ALPHA $\overline{M}_B$

12
14
16
18

$\overline{M}_B$

$\overline{M}_{AF}$

FIG 3

ALPHA $\overline{M}_B$

$\overline{M}_M$

12
14
16
18
19
20
19
22
14
12

$\overline{M}_B$

$\overline{M}_{AF1}$

$\overline{M}_{AF2}$

$\overline{M}_{AF1}$

FIG 4